# EUROPEAN PATENT APPLICATION

(11) **EP 4 513 743 A1**
(43) Date of publication of application: **26.02.2025**
(21) Application number: 23806601.3
(22) Date of filing: 21.03.2023
(51) Int. Cl.: H02P 27/06, H02K 5/22, H02K 11/30, H02K 11/33, H02K 11/27, H02K 11/02, H02K 5/10, H02P 29/68, H05K 7/20

(54) **MOTOR CONTROL APPARATUS, DRIVING APPARATUS, AND ELECTRIC DEVICE**

(30) Priority: 18.05.2022 CN 202221198531 U
(71) Applicant: Contemporary Amperex Technology Co., Limited, Ningde City, Fujian PRC 352100 (CN)
(72) Inventor: LIU, Tian, Ningde, Fujian 352100 (CN); ZHAO, Yuanmiao, Ningde, Fujian 352100 (CN); YAN, Yu, Ningde, Fujian 352100 (CN); WANG, Chunfa, Ningde, Fujian 352100 (CN); LI, Zhanliang, Ningde, Fujian 352100 (CN); HUANG, Yifei, Ningde, Fujian 352100 (CN)
(74) Representative: Gong, Jinping
(86) International application number: PCT/CN2023/082768
(87) International publication number: WO 2023/221641

(57) **Abstract**

The present application provides a motor control device, a drive device and an electric apparatus. The motor control device comprises a case in which a motor inverter and a heating power module are housed, a motor neutral interface, a motor multiphase interface and a battery-powered positive/negative interface being provided on a housing of the case; an output end of each inverter power module of the motor inverter is respectively connected to the motor multiphase interface through an output terminal; an output end of the heating power module is connected to the motor neutral interface through a heating output terminal; a positive input end of the heating power module is connected to the battery-powered positive interface through a high-voltage positive terminal; and a negative input end of the heating power module is connected to the battery-powered negative interface through a high-voltage negative terminal. The motor control device of the present application enables a self-heating function of a battery, and also has the characteristics of a compact structure and a high space utilization, and can be flexibly arranged on an electric apparatus to meet the needs of a user.

## Description

### Technical Field

The present application relates to the technical field of batteries, and in particular to a motor control device, a drive device and an electric apparatus.

### Background Art

Intelligence and electrification are one of the important development directions in the field of intelligent transportation, especially in the field of electrification. With the advancement of materials and technology, the energy density of battery packs is getting higher and higher, and vehicles are also using various types of battery packs as energy sources. Compared with traditional vehicles that mainly use fossil fuels as energy sources, modem vehicles are increasingly using battery packs represented by lithium-ion traction batteries as energy sources.

In an electric vehicle, a motor control device is a key component for converting DC power supply of a battery into AC power consumption of an electric motor and realizing driving operation of the electric motor, and is a core power component of the electric vehicle. Research and development personnel have been pursuing the safety and reliability of the motor control device, and the ability to operate stably for a long time without failure.

However, some traction batteries represented by lithium-ion batteries are limited in charging and discharging performance because an electrolyte becomes viscous at low temperatures and needs to be heated to exert the charging and discharging performance of the traction battery. Therefore, a motor control device is also required to realize the control function of battery heating. After adding more functions, the existing motor control device has problems such as poor electromagnetic compatibility, a complex structure, troublesome installation, inconvenient maintenance, and poor heat dissipation performance.

### Summary of the Utility Model

In view of the above-mentioned problems, the present application provides a motor control device, a drive device and an electric apparatus, which can achieve less installation and manufacturing complexity and lower cost to meet the needs of a user.

In a first aspect, the present application provides a motor control device comprising a case in which a motor inverter and a heating power module are housed, a motor neutral interface, a motor multiphase interface and a battery-powered positive/negative interface being provided on a housing of the case; wherein an output end of each inverter power module of the motor inverter is respectively connected to the motor multiphase interface through an output terminal; an output end of the heating power module is connected to the motor neutral interface through a heating output terminal; a positive input end of the heating power module is connected to the battery-powered positive interface through a high-voltage positive terminal; and a negative input end of the heating power module is connected to the battery-powered negative interface through a high-voltage negative terminal.

In the technical solutions of the embodiments of the present application, a heating power module is added as compared with a conventional motor control device, a motor neutral interface is correspondingly provided on a housing of a case, and an output end of the heating power module is connected to the motor neutral interface, which enables the heating power module to operate when the battery is self-heating, achieves a battery self-heating function, and also has the characteristics of a compact structure and a high space utilization, so that the entire motor assembly comprising the motor control device can be arranged flexibly on the electric apparatus to meet the needs of the user.

In some embodiments, the heating power module is arranged side by side with each inverter power module in the motor inverter. This design makes the motor control device compact and space-efficient.

In some embodiments, the heating power module has the same specification as each inverter power module in the motor inverter. This design allows the heating power module to be installed in a manner consistent with the inverter power module, reducing the space requirements within the case, and achieving easy arrangement and installation.

In some embodiments, the motor neutral interface, the motor multiphase interface, and the battery-powered positive/negative interface are provided on the same side of the case housing. This design allows the various interfaces on the case housing of the motor control device to better accommodate the connection of the entire motor assembly.

In some embodiments, a first current sensor is provided on the heating output terminal. By providing a current sensor on the heating output terminal, an output current of the heating power module can be monitored, improving the safety of the motor control device.

In some embodiments, a control board is housed in the case, the control board being disposed above the heating power module and each of the inverter power modules. This design makes the motor control device compact and space-efficient.

In some embodiments, a low-voltage interface is also provided on the housing of the case; and an output end of the control board is connected to the low-voltage interface through an output terminal. This design allows the various interfaces on the case housing of the motor control device to better accommodate the connection of the entire motor assembly.

In some embodiments, the motor neutral interface, the motor multiphase interface, the battery-powered positive/negative interface, and the low-voltage interface are provided on the same side of the case housing. This design allows the various interfaces on the case housing of the motor control device to better accommodate the connection of the entire motor assembly.

In some embodiments, an electromagnetic isolation plate is arranged between the heating power module and the control board. By arranging an electromagnetic isolation plate between the heating power module and the control board, an effective electromagnetic shield is formed between the two, reducing signal interference.

In some embodiments, a second current sensor is provided on an output terminal of each of the inverter power modules. By providing the current sensor on the output terminal, an output current of the inverter power module can be monitored, improving the safety of the motor control device.

In some embodiments, a cooling module is also provided in the case, the cooling module being provided below the heating power module and each of the inverter power modules, and a coolant inlet and a coolant outlet of the cooling module being provided on the housing of the case. By cooling of the cooling module, the safety of the motor control device can be improved, while this design makes the internal structure of the motor control device compact and space-efficient.

In some embodiments, the motor neutral interface, the motor multiphase interface, the battery-powered positive/negative interface, and the coolant inlet and the coolant outlet of the cooling module are provided on the same side of the case housing. This design allows the various interfaces on the case housing of the motor control device to better accommodate the connection of the entire motor assembly.

In some embodiments, the motor control device also comprises a case cover fastened above the case; and an electromagnetic shielding seal ring is provided in a position where the case is fastened to the case cover. By providing the electromagnetic shielding seal ring in the position where the case is fastened to the case cover, compared with an ordinary waterproof seal ring, the electromagnetic compatibility of the motor control device is improved on the basis of meeting the waterproof performance.

In some embodiments, the heating power module comprises a power tube and a drive board connected to the power tube; and the heating power module is mounted on an inner wall of the case with at least one bolt. This design reduces the space requirements in the case and achieves easy arrangement and installation.

In a second aspect, the present application provides a drive device comprising a drive motor and a motor control device in the above embodiments that is provided for the drive motor.

In a third aspect, the present application provides an electric apparatus comprising the drive device in the above embodiments.

The above description is only an overview of the technical solutions of the present application. To more clearly understand the technical means of the present application to implement same according to the contents of the description, and to make the above and other objectives, features, and advantages of the present application more obvious and understandable, specific implementations of the present application are exemplarily described below.

### Brief Description of the Drawings

Various other advantages and benefits will become apparent to those of ordinary skill in the art upon reading the following detailed description of preferred implementations. The accompanying drawings are merely for the purpose of illustrating the preferred implementations, and should not be construed as limiting the present application. Moreover, the same reference numerals represent the same components throughout the accompanying drawings. In the drawings:
FIG. 1 shows a charging and discharging circuit diagram of a conventional traction battery heating system;
FIG. 2 shows a first schematic structural diagram of a motor control device according to some embodiments of the present application;
FIG. 3 shows a second schematic structural diagram of a motor control device according to some embodiments of the present application; and
FIG. 4 shows a third schematic structural diagram of a motor control device according to some embodiments of the present application; and
FIG. 5 shows a schematic circuit diagram of a motor control device according to an embodiment of the present application.

Reference signs in the Detailed Description of Embodiments:
traction battery heating system 100, battery 110, inverter 120, motor winding 130, motor controller 140;
motor control device 200, case 210, heating power module 230, control board 250, electromagnetic isolation plate 260, electromagnetic shielding seal ring 270;
motor neutral interface 310, W-phase interface 321, V-phase interface 322, U-phase interface 323;
battery-powered positive interface 331, battery-powered negative interface 332, low-voltage interface 255;
coolant inlet 281, coolant outlet 282, isoelectric point 291, explosion-proof valve 292;
mounting point one 211, mounting point two 212, mounting point three 213, mounting point four 214.

### Detailed Description of Embodiments

Embodiments of the technical solutions of the present application will be described in detail below with reference to the accompanying drawings. The following embodiments are merely intended to more clearly illustrate the technical solutions of the present application, so they merely serve as examples, but are not intended to limit the scope of protection of the present application.

Unless otherwise defined, all technical and scientific terms used herein have the same meanings as those commonly understood by those skilled in the art to which the present application belongs. The terms used herein are merely for the purpose of describing specific embodiments, but are not intended to limit the present application. The terms "include/comprise" and "has/have" and any variations thereof in the description and the claims of the present application as well as the brief description of the accompanying drawings described above are intended to cover non-exclusive inclusion.

In the description of the embodiments of the present application, the technical terms "first", "second", etc. are merely used for distinguishing different objects, and are not to be construed as indicating or implying relative importance or implicitly indicating the number, particular order or primary-secondary relationship of the indicated technical features. In the description of the embodiments of the present application, the phrase "a plurality of" means two or more, unless otherwise explicitly and specifically defined.

The phrase "embodiment" mentioned herein means that the specific features, structures, or characteristics described in conjunction with the embodiment can be encompassed in at least one embodiment of the present application. The phrase at various locations in the description does not necessarily refer to the same embodiment, or an independent or alternative embodiment exclusive of another embodiment. Those skilled in the art understand explicitly or implicitly that the embodiment described herein may be combined with another embodiment.

In the description of the embodiments of the present application, the term "a plurality of" refers to two or more, and similarly, "a plurality of groups" refers to two or more groups and "a plurality of pieces" refers to two or more pieces.

In the description of the embodiments of the present application, the orientations or positional relationships indicated by the technical terms "central", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumferential", etc. are based on the orientations or positional relationships shown in the accompanying drawings and are merely intended to facilitate and simplify the description of the embodiments of the present application, rather than indicating or implying that the device or element referred to must have a particular orientation or be constructed and operated in a particular orientation, and therefore cannot be construed as limiting the embodiments of the present application.

In the description of the embodiments of the present application, unless otherwise explicitly specified and defined, the technical terms such as "mount", "connected", "connection", and "fix" should be understood in a broad sense. For example, they may be a fixed connection, a detachable connection, or an integrated connection; may be a mechanical connection or an electric connection; and may be a direct connection or an indirect connection by means of an intermediate medium, or may be communication between interiors of two elements or interaction between the two elements. For those of ordinary skill in the art, the specific meanings of the above terms in the embodiments of the present application can be understood according to specific situations.

At present, from the perspective of the development of the market situation, traction batteries are used more and more widely. The traction batteries are not only used in energy storage power systems such as hydroelectric power plants, thermal power plants, wind power plants and solar power plants, but also widely used in electric transportation means such as electric bicycles, electric motorcycles and electric vehicles and in many fields such as military equipment and aerospace. With the continuous expansion of the application field of traction batteries, the market demand for the traction batteries is also expanding.

The inventors have noted that in an environment of minus thirty degrees, a charging and discharging performance of a battery pack represented by a lithium battery is basically zero. It is therefore very important to study the battery pack to improve the adaptability of an electric apparatus to the environment. Based on the phenomenon that the current low-temperature environment has a great effect on the performance of the battery pack, how to heat the battery pack quickly becomes the focus of the present application.

In order to increase a battery heating efficiency, improve adverse effects of existing heating methods, and enhance the adaptability of the electric apparatus to the low-temperature environment, the applicant has found that a heating power module can be added to an existing motor control device to quickly heat the traction battery by connecting the heating power module to an electric circuit in low-temperature and cold conditions. This is to increase the storage and release of energy from a battery self-heating oscillating circuit. For example, in a battery self-heating circuit with only a motor winding and a motor inverter, if the inductance of the motor winding is too small, the current cannot be further increased in self-heating and thus the heating effect is affected. In addition, if the inductance of the motor winding is too small, it quickly fills up and needs to be released, resulting in more frequent opening and closing of a semiconductor switch in the inverter, and the semiconductor switch needs to withstand a superimposed shock by turning off a spike voltage, as well as higher switching losses, which can easily affect the life of the inverter.

Based on the above considerations, in order to solve the problem of a low heating efficiency caused by too small inductance of the motor winding and the problem of affecting the life of the inverter, the inventors have devised a motor control device after thorough study, wherein a heating power module is disposed within the motor control device to carry out conduction control of the current or a heating loop, so that an inductor conducts with a positive electrode of the battery, and energy stored by the inductor flows to the positive electrode. The inductor conducts with a negative electrode of the battery, and the energy stored by the inductor flows to the negative electrode. This design allows the motor winding to be supplied with a co-current, greatly reducing motor noises and also decreasing the effect on the life of the inverter.

The motor control device and drive device disclosed in the embodiments of the present application may be used in, but not limited to, the electric apparatus such as a vehicle, a ship, or an aircraft. A battery heating system composed of the motor control device and the drive device disclosed in the present application can be used, which facilitates improving the self-heating efficiency of the battery and meeting the needs of a user.

An embodiment of the present application provides an electric apparatus with a battery heating system, which may be used in, but not limited to, an electric toy, a power tool, an electromobile, an electric vehicle, a ship, a spacecraft, etc. The electric toy may include a stationary or mobile electric toy, such as a game console, an electric vehicle toy, an electric ship toy and an electric airplane toy. The spacecraft may include an airplane, a rocket, a space shuttle, a spaceship, etc.

In order to avoid unnecessary costs when the traction battery is heated, the traction battery can be heated by means of a motor circuit.

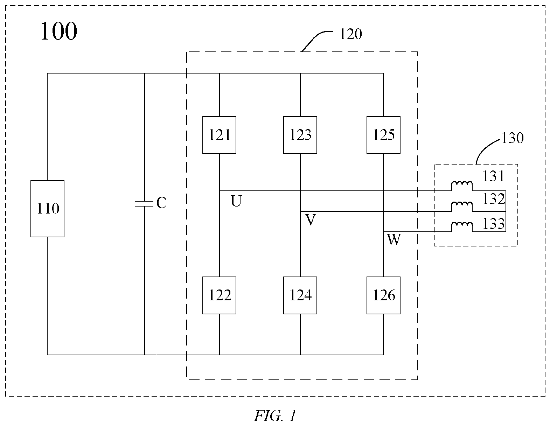

FIG. 1 shows a charging and discharging circuit diagram of a conventional traction battery heating system. As shown in FIG. 1, the traction battery heating system 100 may comprise a battery 110, a motor inverter 120 connected to the battery 110, and a motor winding 130 connected to the motor inverter 120. The traction battery heating system 100 also comprises a motor controller 140 that controls the motor inverter 120.

For the battery 110, it can be implemented not only with the traction battery itself, but also with an external battery such as a charging pile. Heating energy provided by the external battery may be output by an external DC charger, for example, or rectified by an external AC charger, which is not specifically limited herein.

For the motor inverter 120, various types of switches can be implemented. For example, the motor inverter 120 can be implemented by an inverter in a motor drive system, wherein the inverter can be implemented using a bridge-arm switch of an insulated gate bipolar transistor (IGBT). Specifically, the number of bridge arms of the inverter is the same as the number of windings in the motor winding 130. For example, the motor winding 130 comprises a three-phase winding motor, and the inverter comprises a three-phase bridge arm, i.e. a U-phase bridge arm, a V-phase bridge arm and a W-phase bridge arm. Each phase of the three-phase bridge arm has an upper bridge arm and a lower bridge arm, each of which is provided with a switching unit, i.e. the motor inverter 120 comprises an upper bridge arm switch 121 and a lower bridge arm switch 122 in the U-phase bridge arm, an upper bridge arm switch 123 and a lower bridge arm switch 124 in the V-phase bridge arm, and an upper bridge arm switch 125 and a lower bridge arm switch 126 in the W-phase bridge arm, respectively.

For the motor winding 130, it may in particular comprise: a winding 131 connected to the U-phase bridge arm, a winding 132 connected to the V-phase bridge arm, and a winding 133 connected to the W-phase bridge arm.

It should be noted that the motor winding 130 is not limited to a three-phase winding motor, but can also be a six-phase winding motor, a twelve-phase winding motor, etc. Accordingly, the motor inverter 120 may comprise a three-phase bridge arm, a six-phase bridge arm, or a twelve-phase bridge arm, etc.

In some embodiments, the current may be modulated by controlling the switches in the motor inverter 120 to turn on and off periodically. For example, the current is modulated by controlling a target upper bridge arm switch and a target lower bridge arm switch in the motor inverter 120 to turn on and off periodically. In an example, if the target upper bridge arm switch is the upper bridge arm switch 121, the target lower bridge arm switch is the lower bridge arm switch 124 and/or the lower bridge arm switch 126.

It should be noted that periodically turning on and off the target upper bridge arm switch and the target lower bridge arm switch in each cycle may be the same or different, which is not limited herein. For example, the upper bridge arm switch 121 and the lower bridge arm switch 124 are controlled to turn on and off during each cycle. For example, in the first cycle, the upper bridge arm switch 121 and the lower bridge arm switch 124 are controlled to turn on and off; in the second cycle, the upper bridge arm switch 123 and the lower bridge arm switch 122 are controlled to turn on and off; and in the third cycle, the upper bridge arm switch 121, the lower bridge arm switch 124 and the lower bridge arm switch 126 are controlled to turn on and off, i.e. in different cycles, the target upper bridge arm switch and the target lower bridge arm switch can be controlled differently.

It can thus be seen that with the charging and discharging circuit shown in FIG. 1, a target conduction switch comprises at least one upper bridge arm switch and at least one lower bridge arm switch, the at least one upper bridge arm switch and the at least one lower bridge arm switch being located on different bridge arms. Therefore, it is not possible to turn on all the upper or lower bridge arms simultaneously in one cycle, so the direction of the current in different loops formed among the battery, the target upper bridge arm switch, the target lower bridge arm switch and the motor winding is different, resulting in an AC current.

The magnetic motive force of a unidirectional winding is a pulsed magnetic motive force which is spatially distributed in a stepped pattern and alternates regularly over time in accordance with the change of the current. The magnetic motive forces of the three single-phase windings are superimposed to form a resultant magnetic field of the three-phase winding. The currents flowing into the three-phase winding of the three-phase winding motor during heating are not exactly equal in magnitude, the currents flowing through the two-phase windings thereof are 180° out of phase with each other, and the two-phase currents with no phase difference are equal in magnitude. This causes three phases of the current flowing through the motor winding to be asymmetrical to each other, and the high current frequency causes the problem of large motor vibration noises during heating of the traction battery.

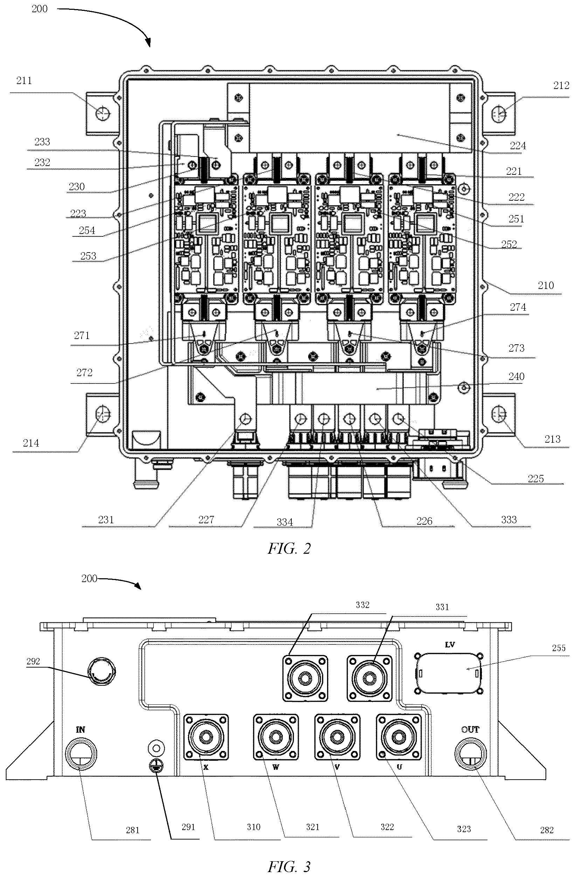

According to some embodiments of the present application, with reference to FIG. 2, FIG. 2 shows a schematic structural diagram of a motor control device 200 according to an embodiment of the present application. The motor control device 200 comprises a case 210 in which three inverter power modules (221, 222, 223) and a heating power module 230 of a motor inverter 220 (not shown in FIG. 2) are housed. The motor inverter 220 also comprises a bus capacitor 224.

Referring to FIG. 3, a motor neutral interface 310, a motor multiphase interface 320 (comprising a W-phase interface 321, a V-phase interface 322, and a U-phase interface 323) and a battery-powered positive interface 331 and a battery-powered negative interface 332 are provided on a housing of the case 210. The housing of the case 210 is also provided with a mounting point one 211, a mounting point two 212, a mounting point three 213, and a mounting point four 214.

Referring to FIGS. 2 and 3, an output end of each inverter power module in the motor inverter 220 is connected to the motor multiphase interface 320 through an output terminal (225, 226, 227), respectively; an output end of the heating power module 230 is connected to the motor neutral interface 310 through a heating output terminal 231; a positive input end 232 of the heating power module 230 is connected to the battery-powered positive interface 331 through a high-voltage positive terminal 333; and a negative input end 233 of the heating power module 230 is connected to the battery-powered negative interface 332 through a high-voltage negative terminal 334. In addition, the present application also provides a shielding magnetic ring 240 for each output terminal.

The present embodiment provides a motor control device to which a heating power module is added as compared with a conventional motor control device, a motor neutral interface is correspondingly provided on a housing of a case, and an output end of the heating power module is connected to the motor neutral interface, which enables the heating power module to operate when the battery is self-heating, achieves a battery self-heating function, and also has the characteristics of a compact structure and a high space utilization, so that the entire motor assembly comprising the motor control device can be arranged flexibly on the electric apparatus to meet the needs of the user.

According to some embodiments of the present application, the heating power module 230 comprises a power tube and a drive board connected to the power tube; and the heating power module 230 is mounted on an inner wall of the case 210 with at least one bolt. This design reduces the space requirements in the case and achieves easy arrangement and installation.

According to some embodiments of the present application, referring to FIG. 2, the heating power module 230 is arranged side by side with each inverter power module (221, 222, 223) in the motor inverter 220. This design makes the motor control device compact and space-efficient.

According to some embodiments of the present application, referring to FIG. 2, the heating power module 230 has the same specification as each inverter power module in the motor inverter 220. This design allows the heating power module to be installed in a manner consistent with the inverter power module, reducing the space requirements within the case, and achieving easy arrangement and installation.

According to some embodiments of the present application, with reference to FIG. 3, the motor neutral interface 310, the motor multiphase interface 320, the battery-powered positive interface 331 and the battery-powered negative interface 332 are provided on the same side of the case housing. This design allows the various interfaces on the case housing of the motor control device to better accommodate the connection of the entire motor assembly.

According to some embodiments of the present application, a first current sensor 271 is provided on the heating output terminal 231 of the heating power module 230. By providing a current sensor on the heating output terminal, an output current of the heating power module 230 can be monitored, improving the safety of the motor control device.

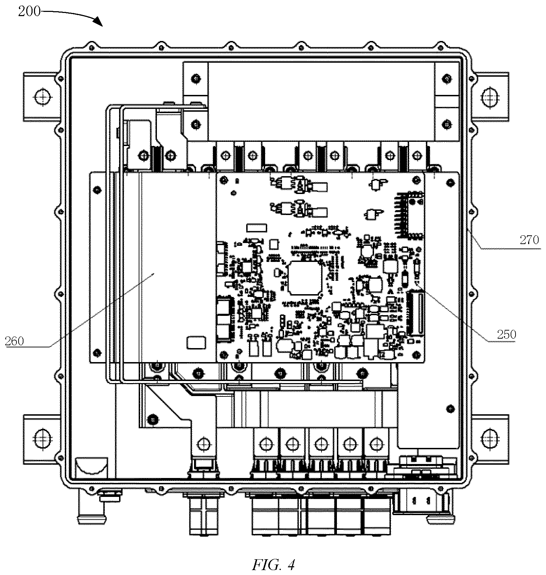

According to some embodiments of the present application, with reference to FIG. 4, a control board 250 is housed in the case 210, the control board 250 being disposed above the heating power module 230 and each inverter power module (221, 222, 223), in particular above the drive board (251, 252, 253, 254) of each power module. This design makes the motor control device compact and space-efficient. The control board 250 is configured to control the heating power module 230 and each inverter power module (221, 222, 223).

According to some embodiments of the present application, with reference to FIG. 3, a low-voltage interface 255 is also provided on the housing of the case 210; and an output end of the control board 250 is connected to the low-voltage interface 255 through an output terminal. This design allows the various interfaces on the case housing of the motor control device to better accommodate the connection of the entire motor assembly.

According to some embodiments of the present application, with reference to FIG. 3, the motor neutral interface 310, the motor multiphase interface 320, the battery-powered positive interface 331, the battery-powered negative interface 332 and the low-voltage interface 255 are provided on the same side of the case housing. This design allows the various interfaces on the case housing of the motor control device to better accommodate the connection of the entire motor assembly.

According to some embodiments of the present application, with reference to FIG. 4, an electromagnetic isolation plate 260 is arranged between the heating power module 230 and the control board 250, in particular between the drive board (251, 252, 253, 254) of the respective power module and the control board 250, forming an effective electromagnetic shield between the two, and reducing signal interference.

According to some embodiments of the present application, referring to FIG. 2, a second current sensor (272, 273, 274) is provided on an output terminal of each of the inverter power modules (221, 222, 223). By providing the current sensor on the output terminal, an output current of the inverter power module can be monitored, improving the safety of the motor control device.

According to some embodiments of the present application, a cooling module (not shown in the figures) is also provided within the case 210, the cooling module being provided below the heating power module 230 and each inverter power module, and a coolant inlet 281 and a coolant outlet 282 of the cooling module being provided on the housing of the case 210, with reference to FIG. 3.

Compared with the prior art, in order to meet the requirements of heat dissipation of the heating power module 230, a portion of a water-cooled area is added inside the case of the present embodiment and is provided at the bottom of the heating power module 230. A coolant enters a water-cooled flow channel inside the case from the coolant inlet 281, exchanges heat with the heating power module 230 and the other three inverter power modules, and then exits from the coolant outlet 282. By cooling of the cooling module, the safety of the motor control device can be improved, while this design makes the internal structure of the motor control device compact and space-efficient.

According to some embodiments of the present application, with reference to FIG. 3, the motor neutral interface 310, the motor multiphase interface 320, the battery-powered positive interface 331, the battery-powered negative interface 332, and the coolant inlet 281 and the coolant outlet 282 of the cooling module are provided on the same side of the case housing. In some embodiments, the low-voltage interface 255, an isoelectric point 291 and an explosion-proof valve 292 are also provided on the same side. This design allows the various interfaces on the case housing of the motor control device to better accommodate the connection of the entire motor assembly.

According to some embodiments of the present application, the motor control device 200 further comprises a case cover (not shown in the figures) fastened above the case 210; and an electromagnetic shielding seal ring 270 is provided in a position where the case 210 is fastened to the case cover.

By providing the electromagnetic shielding seal ring 270 in the position where the case is fastened to the case cover, compared with an ordinary waterproof seal ring, the electromagnetic shielding seal ring improves the electromagnetic compatibility of the motor control device on the basis of meeting the waterproof performance.

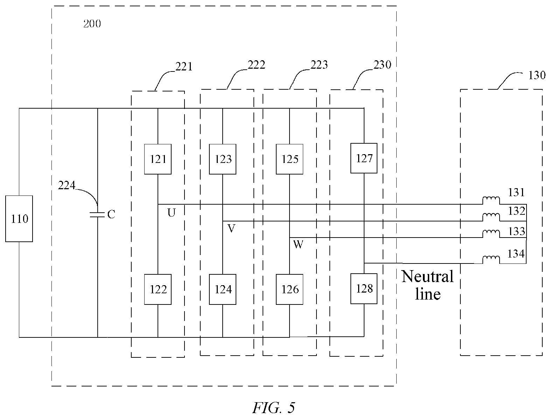

For ease of understanding, reference is made to FIG. 5, which shows a schematic circuit diagram of a motor control device provided in an embodiment of the present application. The heating power module 230 comprises a first switching device 127 and a second switching device 128, enabling a switching function, a charging circuit and a discharging circuit are switched by controlling the on or off of the first switching device 127 and the second switching device 128, and an electric current in an AC waveform is generated in the charging and discharging circuits, thus achieving the effect of heating the battery.

When the charging circuit and the discharging circuit are cycled in these two working modes, the motor winding 130 can be introduced with a co-current, which greatly reduces motor noises while the battery is heated.

The first switching device 127 and the second switching device 128 may each take the form of a switch and a freewheeling diode connected in parallel, or may both take the form of a switching structure, or may one take the form of a switching structure and the other take the form of a diode, which is not limited in the present application.

According to some embodiments of the present application, with reference to FIG. 5, an inductor 134 is also added in the motor winding 130, which may increase storage and release of energy in the battery heating circuit, thereby increasing the current when the battery is self-heating, and further improving the heating effect.

The motor control device provided by the present application has the characteristics of a compact structure, a high space utilization, a low weight, a low cost, etc. At the same time, a motor phase line and a neutral line can be connected to realize a battery self-heating function; and since the motor neutral line is connected, the respective motor phase can be introduced with the same current, the problems of motor noises and rotor overtemperature demagnetization can be improved, and the magnitude of the heating current is affected by a motor-side peak current, which can effectively reduce noises, increase heating power, and improve the comfort of an electric vehicle.

The present application also provides a drive device comprising a drive motor and a motor control device 200 in the above embodiments that is provided for the drive motor.

The present application also provides an electric apparatus comprising the drive device in the above embodiments. The electric apparatus can be a variety of electric vehicles.

Finally, it should be noted that the above embodiments are merely used for illustrating rather than limiting the technical solutions of the present application. Although the present application has been illustrated in detail with reference to the foregoing embodiments, it should be understood by those of ordinary skill in the art that the technical solutions described in the foregoing embodiments may still be modified, or some or all of the technical features thereof may be equivalently substituted; and such modifications or substitutions do not make the essence of the corresponding technical solution depart from the scope of the technical solutions of the embodiments of the present application, and should fall within the scope of the claims and the description of the present application.

## Claims

1. A motor control device, **characterized by** comprising a case in which a motor inverter and a heating power module are housed, a motor neutral interface, a motor multiphase interface and a battery-powered positive/negative interface being provided on a housing of the case;
wherein an output end of each inverter power module of the motor inverter is respectively connected to the motor multiphase interface through an output terminal;
an output end of the heating power module is connected to the motor neutral interface through a heating output terminal; a positive input end of the heating power module is connected to the battery-powered positive interface through a high-voltage positive terminal; and a negative input end of the heating power module is connected to the battery-powered negative interface through a high-voltage negative terminal.

2. The motor control device according to claim 1, **characterized in that** the heating power module is arranged side by side with each inverter power module in the motor inverter.

3. The motor control device according to claim 1 or 2, **characterized in that** the heating power module has the same specification as each inverter power module in the motor inverter.

4. The motor control device according to claim 1 or 2, **characterized in that** the motor neutral interface, the motor multiphase interface, and the battery-powered positive/negative interface are provided on the same side of the case housing.

5. The motor control device according to claim 1 or 2, **characterized in that** a first current sensor is provided on the heating output terminal.

6. The motor control device according to claim 1 or 2, **characterized in that** a control board is housed in the case, the control board being disposed above the heating power module and each of the inverter power modules.

7. The motor control device according to claim 6, **characterized in that** a low-voltage interface is also provided on the housing of the case; and an output end of the control board is connected to the low-voltage interface through an output terminal.

8. The motor control device according to claim 7, **characterized in that** the motor neutral interface, the motor multiphase interface, the battery-powered positive/negative interface and the low-voltage interface are provided on the same side of the case housing.

9. The motor control device according to claim 6, **characterized in that** an electromagnetic isolation plate is arranged between the heating power module and the control board.

10. The motor control device according to claim 1 or 2, **characterized in that** a second current sensor is provided on an output terminal of each of the inverter power modules.

11. The motor control device according to claim 1 or 2, **characterized in that** a cooling module is also provided in the case, the cooling module being provided below the heating power module and each of the inverter power modules, and a coolant inlet and a coolant outlet of the cooling module being provided on the housing of the case.

12. The motor control device according to claim 11, **characterized in that** the motor neutral interface, the motor multiphase interface, the battery-powered positive/negative interface, and the coolant inlet and the coolant outlet of the cooling module are provided on the same side of the case housing.

13. The motor control device according to claim 1 or 2, **characterized in that** the motor control device also comprises a case cover fastened above the case; and an electromagnetic shielding seal ring is provided in a position where the case is fastened to the case cover.

14. The motor control device according to claim 1 or 2, **characterized in that** the heating power module comprises a power tube and a drive board connected to the power tube; and
the heating power module is mounted on an inner wall of the case with at least one bolt.

15. A drive device, **characterized by** comprising a drive motor and a motor control device as claimed in any one of claims 1 to 14 that is provided for the drive motor.

16. An electric apparatus, **characterized by** comprising a drive device as claimed in claim 15.
